# EUROPÄISCHE PATENTANMELDUNG

(11) **EP 2 506 325 A1**
(43) Veröffentlichungstag der Anmeldung: **03.10.2012**
(21) Anmeldenummer: 11160865.9
(22) Anmeldetag: 01.04.2011
(51) Int. Cl.: H01L 41/047, H01L 41/193, H01L 41/26

(54) **Elektromechanischer Wandler, Verfahren zu dessen Herstellung und Verwendung desselben**

(71) Anmelder: Bayer Material Science AG, 51368 Leverkusen (DE)
(72) Erfinder: Jenninger, Werner, (FR); Wagner, Joachim, 51061 Köln (DE)

(57) **Zusammenfassung**

Die Erfindung betrifft einen elektromechanischen Wandler, welcher einen dielektrische Elastomer-Schichtverbund (1) mit einer ersten Seite (1a) und einer der ersten Seite (1a) gegenüberliegenden zweiten Seite (1b) umfasst, wobei der dielektrische Elastomer-Schichtverbund (1) zwischen der ersten und der zweiten Seite (1a,1b) in Dickenrichtung gesehen eine der ersten Seite (1a) zugeordnete erste Elastomer-Randschicht (3), eine Elastomer-Mittelschicht (2) und eine der zweiten Seite (1b) zugeordnete zweite Elastomer-Randschicht (4) umfasst, wobei die erste und die zweite Seite (1a,1b) des dielektrischen Elastomerschichtverbunds (1) gewellt ausgeführt sind unter Ausbildung von Erhebungen (7a,7b) und Vertiefungen (8a,8b), wobei die Erhebungen (7a,7b) und Vertiefungen (8a,8b) vollständig in der der ersten und der zweiten Seite zugeordneten ersten und zweiten Elastomer-Randschicht (3,4) liegen, wobei die Elastomer-Mittelschicht (2) des dielektrischen Elastomerschichtverbunds (1) ein Polyurethanpolymer umfasst, wobei die erste Seite (la) des dielektrischen Elastomerschichtverbunds (1) von einer ersten Elektrode (5) und die zweite Seite (1b) des dielektrischen Elastomerschichtverbunds (1) von einer zweiten Elektrode (6) kontaktiert ist und wobei die erste und zweite Elektrode (5,6) korrespondierend gewellt zu der ersten und zweiten Seite (1a,1b) des dielektrischen Elastomerschichtverbunds (1) ausgeführt sind. Ferner betrifft die Erfindung ein Verfahren zur Herstellung eines solchen Wandlers und eine Verwendung desselben.

## Beschreibung

Die vorliegende Erfindung betrifft einen elektromechanischen Wandler. Sie betrifft weiterhin ein Verfahren zu dessen Herstellung und dessen Verwendung.

Elektromechanische Wandler wandeln elektrische Energie in mechanische Energie um und umgekehrt. Sie können als Bestandteil von Sensoren, Aktuatoren und Generatoren eingesetzt werden. WO 2001/06575 A1 offenbart beispielsweise einen Energieumwandler, seine Verwendung sowie seine Herstellung. Der Energieumwandler wandelt mechanische Energie in elektrische Energie um. Einige der gezeigten Energieumwandler weisen vorgespannte Polymere auf. Die Vorspannung verbessert die Umwandlung zwischen elektrischer und mechanischer Energie. Darüber hinaus wird eine Vorrichtung offenbart, welche ein elektroaktives Polymer als dielektrisches Elastomer zur Umwandlung von elektrischer Energie in mechanische Energie umfasst. Des Weiteren werden Elektroden offenbart, welche an die Form des Polymers in dem Energieumwandler angepasst sind. Auch werden Verfahren zur Herstellung einer elektromechanischen Vorrichtung offenbart, welche ein oder mehrere elektroaktive Polymere umfasst.

Bei einer Dehnung des dielektrischen Elastomers ist es wünschenswert, wenn die das Elastomer kontaktierenden Elektroden dieser Dehnung folgen können. Bei flachen Elastomerschichten bedingt diese Anforderung in der Regel dehnfähige Elektrodenkonstruktionen oder Elektrodenmaterialien. Als Ausweg aus dieser Beschränkung wurden strukturierte Oberflächen der Elastomere vorgeschlagen.

Schichtenverbunde aus dielektrischen Elastomeren und anderen Materialien für elektromechanische Wandler werden in US 2009/0169829 A1 offenbart. Diese Patentanmeldung beschäftigt sich mit einem Mehrschichtverbund mit einem Film, einer ersten elektrisch leitfähigen Schicht und wenigstens einer Zwischenschicht, die zwischen dem Film und der ersten elektrisch leitfähigen Schicht angeordnet ist. Der Film ist aus einem dielektrischen Material gemacht und weist eine erste und zweite Oberfläche auf. Wenigstens die erste Oberfläche umfasst ein Oberflächenmuster mit Erhöhungen und Vertiefungen. Die erste elektrisch leitfähige Schicht ist auf dem Oberflächenmuster angebracht und weist eine Wellenform auf, die durch das Oberflächenmuster des Films gebildet wird.

Gemäß einer Ausführungsform der in dieser Patentanmeldung beschriebenen Erfindung kann die Zwischenschicht durch Plasmabehandlung der Filmoberfläche erhalten werden. Dabei dient die Zwischenschicht der Verbesserung der Haftung zwischen der elektrisch leitfähigen Schicht und dem Film.

DE 100 54 247 A1 beschreibt ein Betätigungselement mit einem Körper aus einem Elastomermaterial, der auf zwei einander gegenüberliegenden Begrenzungsflächen mit jeweils einer Elektrode versehen ist. Hierbei möchte man die Dynamik verbessern können. Hierzu weist mindestens eine Begrenzungsfläche mindestens einen gewellten Bereich mit parallel zur Querrichtung verlaufenden Höhen und Tiefen als Extreme auf, der von einer Elektrode bedeckt ist, die zumindest einen Teil der Extreme vollflächig abdeckt und im übrigen über den gewellten Bereich zusammenhängt.

US 2009/072658 A1 offenbart einen Film aus einem dielektrischen Material mit einer ersten Oberfläche und einer zweiten Oberfläche, wobei mindestens die erste Oberfläche ein Oberflächenmuster aus erhobenen und vertieften Oberflächenabschnitten umfasst. Eine erste elektrisch leitfähige Schicht ist auf dem Oberflächenmuster angeordnet und die elektrisch leitfähige Schicht weist eine gewellte Form auf, welche durch das Oberflächenmuster des Films gebildet wird. Die zweite Oberfläche ist im Wesentlichen flach.

Wenn nicht beide Seiten einer dielektrischen Elastomerfolie eine gewellte Form aufweisen, kommt es zu relativen Schwankungen in der Schichtdicke bei einer Dehnung. Dieses ist jedoch unerwünscht.

US 2005/104145 A1 offenbart dielektrische Aktuatoren von der Art, in denen die elektrostatische Anziehungskraft zwischen zwei an einem elastomeren Körper angeordneten Elektroden zu einer Kompression des Körpers in eine erste Richtung und einer entsprechenden Dehnung des Körpers in eine zweite Richtung führt. Die dielektrische Aktuator-/Sensorstruktur umfasst eine erste Platte aus einem elastomeren Material mit mindestens einer glatten Oberfläche und einer zweiten Oberfläche und eine zweite Platte aus einem elastomeren Material mit mindestens einer glatten Oberfläche und einer zweiten Oberfläche. Die Platten sind aufeinander laminiert, so dass ihre zweiten Oberflächen freiliegen. Eine erste Elektrode auf der zweiten Oberfläche der ersten Platte und eine zweite Elektrode auf der zweiten Oberfläche der zweiten Platte werden bereitgestellt.

Der vorliegenden Erfindung liegt die Aufgabe zugrunde, einen elektromechanischen Wandler der eingangs genannten Art anzugeben, in dem die Möglichkeit des Einsatzes auch von üblicherweise nicht geeigneten, nicht oder nur wenig dehnfähigen Elektrodenmaterialien besteht und welcher auf einfache Weise herstellbar ist. Ferner sollen Materialien verwendet werden, die einerseits eine einfache Oberflächenstrukturierbarkeit ermöglichen und andererseits eine hohe Dielektrizitätskonstante des zwischen den Elektroden befindlichen Materials sicherstellen, um eine hohe Betriebssicherheit des elektromechanischen Wandlers zu gewährleisten.

Die Aufgabe wird erfindungsgemäß dadurch gelöst, dass der Wandler einen dielektrische Elastomer-Schichtverbund mit einer ersten Seite und einer der ersten Seite gegenüberliegenden zweiten Seite umfasst, wobei der dielektrische Elastomer-Schichtverbund zwischen der ersten und der zweiten Seite in Dickenrichtung gesehen eine der ersten Seite zugeordnete erste Elastomer-Randschicht, eine Elastomer-Mittelschicht und eine der zweiten Seite zugeordnete zweite Elastomer-Randschicht umfasst, wobei die erste und die zweite Seite des dielektrischen Elastomer-Schichtverbunds gewellt ausgeführt sind unter Ausbildung von Erhebungen und Vertiefungen, wobei die Erhebungen und Vertiefungen vollständig in der der ersten und der zweiten Seite zugeordneten ersten und zweiten Elastomer-Randschicht liegen, wobei die Elastomer-Mittelschicht des dielektrischen Elastomer-Schichtverbunds ein Polyurethanpolymer umfasst, wobei die erste Seite des dielektrischen Elastomer-Schichtverbunds von einer ersten Elektrode und die zweite Seite des dielektrischen Elastomer-Schichtverbunds von einer zweiten Elektrode kontaktiert ist und wobei die erste und zweite Elektrode korrespondierend gewellt zu der ersten und zweiten Seite des dielektrischen Elastomer-Schichtverbunds ausgeführt sind.

Erfindungsgemäß umfasst der dielektrische Elastomer-Schichtverbund des elektromechanischen Wandlers zwei Elastomer-Randschichten und eine dazwischen angeordnete Elastomer-Mittelschicht. Die Elastomer-Mittelschicht ist mit den Elastomer-Randschichten verbunden, wodurch der Elastomer-Schichtverbund ausgebildet wird. Dabei werden die gewellte erste und zweite Seite des Elastomer-Schichtverbunds durch eine entsprechende Wellenstruktur in Elastomer- Randschichten gebildet.

Der besondere Vorteil des erfindungsgemäßen elektromechanischen Wandlers liegt in einer vergleichsweise einfachen Herstellbarkeit. So können die Elastomer-Randschichten einseitig mit einer gewellten Struktur ausgeführt werden, wie beispielsweise in US 2009/0072658 A1 beschrieben, während die Elastomer-Mittelschicht, die keine wellige Struktur aufzuweisen braucht, sich vor allem durch gute elektromechanische Eigenschaften, wie z.B. eine hohe dielektrische Konstante, auszeichnet. Hierzu umfasst die Elastomer- Mittelschicht erfindungsgemäß ein Polyurethanpolymer. Geeignete Polyurethanklassen sind beispielsweise thermoplastische Polyurethanelastomere und Polyurethan-Gießelastomere.

Einzelheiten zur Zusammensetzung der Polyurethanelastomere sind der bislang unveröffentlichten europäischen Patentanmeldung 10192847.1 zu entnehmen, auf deren Inhalt hiermit vollumfänglich Bezug genommen wird. Es wurde gefunden, dass solche Polyurethanpolymere gute elastomere Eigenschaften aufweisen und sich als dielektrische Elastomere in elektromechanischen Aktorsystemen eignen können. Insbesondere ist eine hohe maximale Dehnung vorteilhaft. Vorzugsweise ist das Polyurethanelastomer ein dielektrisches Elastomer mit einem spezifischen elektrischen Volumenwiderstand gemäß ASTM D 257 von ≥ 10¹² bis ≤ 10¹⁷ Ohm cm. Es ist weiterhin möglich, dass das Polyurethanpolymer eine dielektrische Durchbruchsfeldstärke gemäß ASTM 149-97a von ≥ 50 V/µm bis ≤ 200 V/µm aufweist.

Füllstoffe können beispielsweise die Dielektrizitätskonstante des Polymerelements regulieren. Vorzugsweise umfasst die Reaktionsmischung Füllstoffe zur Erhöhung der Dielektrizitätskonstanten wie Füllstoffe mit einer hohen Dielektrizitätskonstante. Beispiele hierfür sind keramische Füllstoffe, insbesondere Bariumtitanat, Titandioxid und piezoelektrische Keramiken wie Quarz oder Bleizirkoniumtitanat, sowie organische Füllstoffe, insbesondere solche mit einer hohen elektrischen Polarisierbarkeit, beispielsweise Phthalocyanine.

Außerdem ist eine hohe Dielektrizitätskonstante auch durch das Einbringen elektrisch leitfähiger Füllstoffe unterhalb der Perkolationsschwelle erzielbar. Beispiele hierfür sind Ruß, Graphit, einwandige oder mehrwandige Kohlenstoff-Nanoröhrchen, elektrisch leitfähige Polymere wie Polythiophene, Polyaniline oder Polypyrrole, oder Mischungen davon. In diesem Zusammenhang sind insbesondere solche Rußtypen von Interesse, die eine Oberflächenpassivierung aufweisen und deshalb bei niedrigen Konzentrationen unterhalb der Perkolationsschwelle zwar die Dielektrizitätskonstante erhöhen und trotzdem nicht zu einer Erhöhung der Leitfähigkeit des Polymers führen.

Die welligen Seiten des Elastomerschichtverbundes können dann mit Elektroden versehen werden und lassen genug Freiraum für Dehnungen in Richtung der Welligkeit, ohne dass eine an sich unflexible Elektrodenschicht reißen würde.

Unter "gewellt" ist ein wellenförmiges Querschnittsprofil mit einer regelmäßigen oder unregelmäßigen Abfolge von Erhebungen und Vertiefungen zu verstehen. Bevorzugt ist hierbei eine regelmäßige Abfolge.

Ein Beispiel für ein wellenförmiges Profil ist, wenn in einer Elastomerschicht, insbesondere einem Elastormer-Schichtverbund, welcher neben der Dickenrichtung, eine Längsrichtung und eine Querrichtung aufweist, das wellenförmige Profil in Längsrichtung gebildet wird.

Nach einer vorteilhaften Ausgestaltung der Erfindung umfassen die erste und die zweite Elastomer-Randschicht der dielektrischen Elastomerschicht jeweils ein Silikonelastomer. Silikonelastomere weisen zwar eine geringere Dielektrizitätskonstante auf als Polyurethanpolymere, jedoch eignen sie sich in besonderer Weise für eine Oberflächenstrukturierung, insbesondere für die Einbringung einer Wellenstruktur. Um nun für den gesamten Elastomer-Schichtverbund gute elektromechanische Eigenschaften, wie z.B. eine hohe Dielektrizitätskonstante, sicherzustellen, ist es sinnvoll, den Dickenanteil der das Polyurethan umfassenden Elastomer-Mittelschicht möglichst groß zu wählen.

Alternativ zu dem Vorstehenden können die die erste und die zweite Elastomer-Randschicht der dielektrischen Elastomerschicht jeweils ein Polyurethanpolymer umfassen. Hierbei wird für die Elastomer-Randschichten bevorzugt ein solches Poyurethanpolymer ausgewählt, welches sich in besonderer Weise für die Einbringung einer Wellenstruktur in jeweils eine Seite der Elastomer-Randschichten eignet.

Der dielektrische Elastomer-Schichtverbund kann beispielsweise eine maximale Spannung von ≥ 0,2 MPa und eine maximale Dehnung von ≥ 100 % aufweisen. Im Dehnungsbereich bis ≤ 200 % kann die Spannung von ≥ 0,1 MPa bis ≤ 50 MPa betragen (Bestimmung nach ASTM D 412). Ferner kann das Elastomer ein Elastizitätsmodul bei einer Dehnung von 100 % von ≥ 0,1 MPa bis ≤ 100 MPa aufweisen (Bestimmung nach ASTM D 412).

Es ist möglich, dass der Elastomer-Schichtverbund kompakt ausgeführt ist. Hierunter ist im Rahmen der vorliegenden Erfindung zu verstehen, dass der Anteil an Hohlräumen innerhalb der jeweiligen Schichten > 0 Volumen-% bis < 5 Volumen-% und insbesondere > 0 Volumen-% bis < 1 Volumen-% beträgt.

Die Elektroden sind erfindungsgemäß korrespondierend gewellt zu der ersten und zweiten Seite des dielektrischen Elastomer-Schichtverbunds ausgeführt. Dies bedeutet, dass sie der Welligkeit der ersten und zweiten Seite der dielektrischen Elastomerschicht folgen. Weiterhin können die Elektroden strukturiert sein. Eine strukturierte Elektrode kann beispielsweise als leitende Beschichtung in Streifen oder in Gitterform ausgestaltet sein. Hierdurch kann zusätzlich die Sensitivität des elektromechanischen Wandlers beeinflusst und auf bestimmte Anwendungen angepasst werden. So können die Elektroden derart strukturiert sein, dass der Wandler aktive und passive Bereiche aufweist. Insbesondere können die Elektroden derart strukturiert sein, dass Signale ortsaufgelöst detektiert oder aktive Bereiche gezielt angesteuert werden können. Dieses kann dadurch erzielt werden, dass die aktiven Bereiche mit Elektroden versehen sind, wogegen die passiven Bereiche keine Elektroden aufweisen.

Die Dicke des dielektrischen Elastomer-Schichtverbunds kann zum Beispiel in einem Bereich von ≥ 10 µm bis ≤ 500 µm und vorzugsweise > 20 µm bis < 200 µm liegen. Die Schichtdicke der ersten und/oder zweiten Elektrode kann beispielsweise in einem Bereich von ≥ 0,01 µm bis ≤ 50 µm und vorzugsweise > 0,03 µm bis < 20 µm liegen.

Erfindungsgemäß umfasst das dielektrische Elastomer ein Polyurethanpolymer. Dabei kann das dielektrische Elastomer ausschließlich durch das Polyurethanpolymer gebildet sein. Besonders bevorzugt wird jedoch eine Ausgestaltung, nach der die Elastomer-Randschichten jeweils ein Silikonelastomer umfassen, während die Elastomer-Mittelschicht erfindungsgemäß ein Polyurethanpolymer umfasst.

Nach einer vorteilhaften Ausgestaltung der Erfindung sind die erste und die zweite Seite des dielektrischen Elastomer-Schichtverbunds zueinander gleichsinnig gewellt ausgeführt. "Gleichsinnig gewellt" bedeutet bei einer gewellten Schicht, dass Erhebungen in der Schicht auf der Oberseite (erste Seite) mit entsprechenden Vertiefungen in der Schicht auf der Unterseite (zweite Seite) und Vertiefungen in der Schicht auf der Oberseite mit entsprechenden Erhebungen in der Schicht auf der Unterseite korrespondieren. Insofern kann bei Vorliegen eines wellenförmigen Querschnittsprofils die Schichtdicke der gleichsinnig gewellten Schicht konstant sein. Eine solche gleichsinnige Wellenstruktur ist insbesondere dann vorteilhaft, wenn die Wellenamplitude, d.h. die Höhendifferenz zwischen Erhebungen und Vertiefungen, etwa im Bereich der Gesamtschichtdicke liegt. Ist umgekehrt die Wellenamplitude sehr viel kleiner als die Gesamtschichtdicke, wird eine gute Dehnbarkeit auch bei nicht gleichsinniger Welligkeit erreicht.

In einer weiteren Ausführungsform des erfindungsgemäßen elektromechanischen Wandlers weist das Material des dielektrischen Elastomer-Schichtverbunds eine mittlere dielektrische Konstante εᵣ von > 2 auf. Diese dielektrische Konstante kann auch in einem Bereich von ≥ 2 bis ≤ 10000 oder von ≥ 3 bis ≤ 1000 liegen. Die Bestimmung dieser Konstante kann gemäß ASTM 150-98 erfolgen.

In einer weiteren Ausführungsform des erfindungsgemäßen elektromechanischen Wandlers ist das Material der ersten Elektrode und/oder der zweiten Elektrode ausgewählt aus der Gruppe umfassend Metalle, Metalllegierungen, leitfähige Oligo- oder Polymere, leitfähige Oxide und/oder mit leitfähigen Füllstoffen gefüllten Polymeren. Als leitfähige Oligo- oder Polymere können beispielsweise Polythiophene, Polyaniline oder Polypyrrole eingesetzt werden. Als Füllstoffe für mit leitfähigen Füllstoffen gefüllte Polymere können beispielsweise Metalle, leitfähige Kohlenstoff basierte Materialien, wie Ruß, Kohlenstoff-Nanoröhrchen (carbon nanotubes, CNT) oder leitfähige Oligo- oder Polymere eingesetzt werden. Der Füllstoffgehalt der Polymere liegt dabei vorzugsweise oberhalb der Perkolationsschwelle, so dass die leitfähigen Füllstoffe durchgehend elektrisch leitfähige Pfade innerhalb der mit leitfähigen Füllstoffen gefüllten Polymere ausbilden.

In einer weiteren Ausführungsform des erfindungsgemäßen elektromechanischen Wandlers liegt das Dickenverhältnis zwischen dem dielektrischen Elastomer-Schichtverbunds und der ersten und/oder zweiten Elektrode in einem Bereich von ≥ 1:5 bis ≤ 50000:1. Die Dickenverhältnisse sind jeweils für die Dicke der Elastomerschicht und einer Elektrode angegeben und können auch in einem Bereich von ≥ 100:1 bis ≤ 250:1 liegen.

In einer weiteren Ausführungsform des erfindungsgemäßen elektromechanischen Wandlers sind die erste und die zweite Seite des dielektrischen Elastomer-Schichtverbunds sinusförmig gewellt, dreieckförmig gewellt oder rechteckförmig gewellt ausgeführt. Es ist günstig, wenn das wellenförmige Querschnittsprofil des dielektrischen Elastomer-Schichtverbunds ein Sinuswellenprofil oder ein Dreieckwellenprofil ist. Diese Wellenformen sind hier so zu verstehen, dass beliebige in der Höhe und/oder Breite skalierte Sinus- oder Dreieckswellen zum Einsatz kommen können. Bevorzugt sind jedoch Sinuswellen, die der Beziehung y = Asin(Bx) gehorchen sowie Dreieckswellen, bei denen die Spitze des Dreiecks einen rechten Winkel bildet.

In einer weiteren Ausführungsform des erfindungsgemäßen elektromechanischen Wandlers liegt die Wellenlänge der gewellt ausgeführten ersten und zweiten Seite der dielektrischen Elastomerschicht in einem Bereich von ≥ 1 µm bis ≤ 5000 µm. Die Wellenlänge ist hierbei insbesondere als der Abstand von einer Erhebung zur benachbarten Erhebung zu verstehen und kann vorzugsweise > 5 µm bis < 2000 µm betragen.

In einer weiteren Ausführungsform des erfindungsgemäßen elektromechanischen Wandlers liegt die Wellenamplitude der gewellt ausgeführten ersten und zweiten Seite der dielektrischen Elastomerschicht in einem Bereich von ≥ 0,3 µm bis ≤ 5000 µm. Die doppelte Wellenamplitude ist hierbei als der vertikale Abstand zwischen dem tiefsten Punkt einer Vertiefung und dem höchsten Punkt einer benachbarten Erhöhung zu verstehen und kann vorzugsweise > 5 µm bis < 2000 µm betragen.

Die vorliegende Erfindung betrifft weiterhin ein Verfahren zur Herstellung eines erfindungsgemäßen elektromechanischen Wandlers, umfassend die Schritte:
(a1) Bereitstellen einer dielektrischen Elastomer-Mittelschicht mit einer ersten Seite und einer der ersten Seite gegenüberliegenden zweiten Seite, wobei die dielektrische Elastomer-Mittelschicht ein **Polyurethanpolymer umfasst**,
(b1) Bereistellen einer ersten und einer zweiten dielektrischen Elastomer-Randschicht, wobei die erste und die zweite dielektrische Elastomer-Randschicht jeweils eine erste und eine zweite Seite aufweisen, wobei die jeweils erste Seite der ersten und der zweiten dielektrischen Elastomer-Randschicht gewellt ausgeführt sind unter Ausbildung von Erhebungen und Vertiefungen,
(c1) Kontaktieren der gewellten ersten Seite der ersten dielektrischen Elastomer-Randschicht mit einer ersten Elektrode und Kontaktierung der ersten gewellten Seite der zweiten dielektrischen Elastomer-Randschicht mit einer zweiten Elektrode,
   wobei das Kontaktieren derart erfolgt, dass die erste und zweite Elektrode korrespondierend gewellt zu den gewellten Seiten des dielektrischen Elastomer-Schichtverbunds ausgeführt sind,
(d1) Verbinden der jeweils zweiten Seiten der ersten und der zweiten dielektrischen Elastomer-Randschicht mit der ersten und der zweiten Seite der dielektrischen Elastomer-Mittelschicht unter Ausbildung eines dielektrischen Elastomer-Schichtverbunds,

Das Kontaktieren der jeweils ersten Seiten der Elastomer-Randschichten mit den Elektroden kann auch nach der Verbindung zwischen Elastomer-Randschichten und Elastomer-Mittelschicht erfolgen.

Zur Herstellung der Elastomer-Mittelschicht und der Elastomer-Randschichten können Lösungsmittel-basierte oder Extrusions- und Coextrusionsverfahren zum Einsatz kommen.

Die dielektrischen Elastomer-Randschichten können mit der dielektrischen Elastomer-Mittelschicht auf verschiedene Weise verbunden werden, beispielsweise mittels Kleben oder Laminieren.

Die dielektrischen Elastomer-Randschichten kann beispielsweise direkt von einer Rolle mit den Elektroden kontaktiert werden, so dass ein "roll-to-roll"-Prozess ermöglicht wird.

Ferner kann auch die Verbindung der Randschichten mit der Mittelschicht über einen "roll-to-roll"-Prozess erfolgen.

Die Elektroden können mit mittels üblicher Verfahren wie Sputtern, Sprühen, Aufdampfen, chemische Gasphasenabscheidung (CVD), Drucken, Rakeln und Spincoating auf den dielektrischen Elastomer-Schichtverbund aufgetragen werden.

Ein weiterer Gegenstand der vorliegenden Erfindung ist die Verwendung eines erfindungsgemäßen elektromechanischen Wandlers als Aktor, Sensor oder Generator. Die Verwendung kann beispielsweise im elektromechanischen und/oder elektroakustischen Bereich erfolgen. Insbesondere können erfindungsgemäße elektromechanische Wandler im Bereich der Energiegewinnung aus mechanischen Schwingungen ("energy harvesting"), der Akustik, des Ultraschalls, der medizinischen Diagnostik, der akustischen Mikroskopie, der mechanischen Sensorik, insbesondere Druck-, Kraft- und/oder Dehnungssensorik, der Robotik und/oder der Kommunikationstechnologie, insbesondere in Lautsprechern, Schwingungswandlern, Lichtdeflektoren, Membranen, Modulatoren für Glasfaseroptik, pyroelektrischen Detektoren, Kondensatoren und Kontrollsystemen verwendet werden.

Die vorliegende Erfindung betrifft ebenfalls einen Aktor, Sensor oder Generator, umfassend einen erfindungsgemäßen elektromechanischen Wandler. Hinsichtlich der Details und spezieller Ausführungsformen wird auf die obigen Ausführungen zum Wandler verwiesen.

Die Erfindung wird anhand der nachfolgenden Zeichnung weiter erläutert, ohne jedoch darauf beschränkt zu sein. Es zeigt:

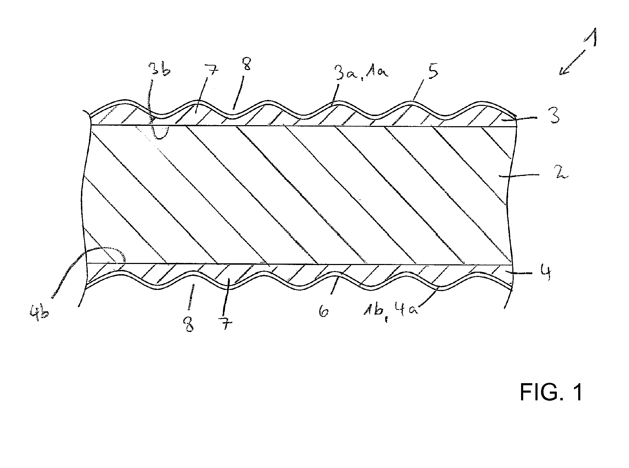

### FIG. 1 einen elektromechanischen Wandler

FIG. 1 zeigt einen elektromechanischen Wandler in Querschnittsansicht. Die Dickenrichtung dieser Anordnung verläuft in der Zeichnung vertikal und die Längsrichtung horizontal. Der elektromechanische Wandler umfasst einen dielektrischen Elastomer-Schichtverbund 1 mit einer ersten und einer zweiten Seite 1a, 1b, wobei der Elastomer-Schichtverbund 1 in Dickenrichtung gesehen drei Schichten umfasst, nämlich eine erste Elastomer-Randschicht 3, eine Elastomer-Mittelschicht 2 und eine zweite Elastomer-Randschicht 4. Der Elastomer-Schichtverbund 1 weist eine wellenförmig strukturierte erste Seite (Oberseite) und eine wellenförmig strukturierte zweite Seite (Unterseite) auf, wobei die erste Seite durch eine entsprechende wellenförmig strukturierte erste Seite 3a der ersten Elastomer-Randschicht 3 und die zweite Seite durch eine entsprechende wellenförmig strukturierte erste Seite 4b der Elastomer-Randschicht 4 gebildet wird. Wellenlänge und Amplitude der Wellenstruktur sind relativ zu den Schichtdicken der einzelnen Elastomerschichten 2, 3, 4 aus Gründen der Übersichtlichkeit nicht maßstabsgerecht dargestellt.

Der dielektrische Elastomer-Schichtverbund 1 ist gleichsinnig wellenförmig ausgeführt. Hierbei korrespondieren Erhebungen 7a auf der ersten Seite 1a des Elastomer-Schichtverbunds 1, die der ersten Seite 3a der ersten Elastomer-Randschicht 3 entspricht, mit entsprechenden Vertiefungen 8b auf der zweiten Seite 1b des Elastomer-Schichtverbunds 1, die der ersten Seite 4a der zweiten Elastomer-Randschicht 4 entspricht, und Vertiefungen 8a auf der ersten Seite 1a des Elastomer-Schichtverbunds 1 mit entsprechenden Erhebungen 7b auf der zweiten Seite 1b des Elastomer-Schichtverbunds 1. Insofern ist bei Vorliegen eines gleichsinnig wellenförmigen Querschnittsprofils die Schichtdicke des Elastomer-Schichtverbunds 1 konstant. Wie in Fig. 1 dargestellt, liegen die Erhebungen 7a, 7b und Vertiefungen 8a, 8b vollständig in den der ersten und der zweiten Seite 1a, 1b des Elastomer-Schichtverbunds 1 zugeordneten ersten und zweiten Elastomer-Randschicht 3, 4, während die der Elastomer-Mittelschicht 2 jeweils zugewandten Seiten 3b, 4b der Elastomer-Randschichten 3, 4 im Wesentlichen flach ausgebildet sind, was der jeweiligen Geometrie der Oberflächen der Elastomer-Mittelschicht 2 entspricht.

Die Elastomer-Mittelschicht 2 enthält ein Polyurethanpolymer, während die beiden Elastomer-Randschichten 3, 4 ein Silikon-Elastomer enthalten. Dies hat den Vorteil, dass die Wellenstruktur in ein leicht verformbares Material eingebracht werden kann, während der überwiegende Anteil des Elastomer-Schichtverbunds 1 ein Material enthält, welches sich durch eine besonders gute elektromechanische Eigenschaften, wie z.B. eine besonders hohe Dielektrizitätskonstante, auszeichnet.

Die jeweils zweite Seite 3b, 4b der ersten und der zweiten Elastomer-Randschicht 3, 4 sind mit den beiden Seiten der Elastomer-Mittelschicht 2 form- und stoffschlüssig verbunden, beispielsweise mittels Kleben oder Laminieren.

Der dielektrische Elastomer-Schichtverbund 1 ist auf der ersten Seite der ersten Elastomer-Randschicht 3 von einer ersten Elektrode 5 kontaktiert. Die zweite Elektrode 6 befindet sich an der ersten Seite der Elastomer-Randschicht 4. Hinsichtlich der Ausgestaltung der Elektroden sind die erste und zweite Elektrode 5,6 korrespondierend gewellt zu der jeweils ersten Seiten der ersten und zweiten Elastomer-Randschicht 3, 4 ausgeführt. Somit ist auch die Schichtdicke der ersten und zweiten Elektrode 5,6 bei dem gezeigten wellenförmigen Querschnittsprofil konstant.

## Patentansprüche

1. Elektromechanischer Wandler,
**dadurch gekennzeichnet, dass**
der Wandler einen dielektrische Elastomer-Schichtverbund (1) mit einer ersten Seite (1a) und einer der ersten Seite (1a) gegenüberliegenden zweiten Seite (1b) umfasst,
- wobei der dielektrische Elastomer-Schichtverbund (1) zwischen der ersten und der zweiten Seite (1a, 1b) in Dickenrichtung gesehen eine der ersten Seite (1a) zugeordnete erste Elastomer-Randschicht (3), eine Elastomer-Mittelschicht (2) und eine der zweiten Seite (1b) zugeordnete zweite Elastomer-Randschicht (4) umfasst,
- wobei die erste und die zweite Seite (1a, 1b) des dielektrischen Elastomerschichtverbunds (1) gewellt ausgeführt sind unter Ausbildung von Erhebungen (7a, 7b) und Vertiefungen (8a, 8b), wobei die Erhebungen (7a, 7b) und Vertiefungen (8a, 8b) vollständig in der der ersten und der zweiten Seite zugeordneten ersten und zweiten Elastomer-Randschicht (3, 4) liegen,
- wobei die Elastomer-Mittelschicht (2) des dielektrischen Elastomerschichtverbunds (1) ein Polyurethanpolymer umfasst,
- wobei die erste Seite (1a) des dielektrischen Elastomerschichtverbunds (1) von einer ersten Elektrode (5) und die zweite Seite (1b) des dielektrischen Elastomerschichtverbunds (1) von einer zweiten Elektrode (6) kontaktiert ist und
- wobei die erste und zweite Elektrode (5, 6) korrespondierend gewellt zu der ersten und zweiten Seite (1a, 1b) des dielektrischen Elastomerschichtverbunds (1) ausgeführt sind.

2. Elektromechanischer Wandler nach Anspruch 1,
**dadurch gekennzeichnet, dass**
die erste und die zweite Elastomer-Randschicht (3, 4) des dielektrischen Elastomer-Schichtverbunds (1) jeweils ein Silikonelastomer umfassen.

3. Elektromechanischer Wandler nach Anspruch 1,
**dadurch gekennzeichnet, dass**
die erste und die zweite Elastomer-Randschicht (3, 4) des dielektrischen Elastomer-Schichtverbunds (1) jeweils ein Polyurethanpolymer umfassen.

4. Elektromechanischer Wandler nach einem der Ansprüche 1 bis 3,
**dadurch gekennzeichnet, dass**
die erste und die zweite Seite (1a, 1b) des dielektrischen Elastomer-Schichtverbunds (1) zueinander gleichsinnig gewellt ausgeführt sind.

5. Elektromechanischer Wandler nach einem der Ansprüche 1 bis 4,
**dadurch gekennzeichnet, dass**
das Material des dielektrischen Elastomer-Schichtverbunds (1) eine mittlere dielektrische Konstante εᵣ von ≥ 2 aufweist.

6. Elektromechanischer Wandler nach einem der Ansprüche 1 bis 5,
**dadurch gekennzeichnet, dass**
das Material der ersten Elektrode (5) und/oder der zweiten Elektrode (6) ausgewählt ist aus der Gruppe umfassend Metalle, Metalllegierungen, leitfähige Oligo- oder Polymere, leitfähige Oxide und/oder mit leitfähigen Füllstoffen gefüllten Polymeren.

7. Elektromechanischer Wandler nach einem der Ansprüche 1 bis 6,
**dadurch gekennzeichnet, dass**
das Dickenverhältnis zwischen dem dielektrischer Elastomer-Schichtverbund (1) und der ersten und/oder zweiten Elektrode (5, 6) in einem Bereich von ≥ 1:5 bis ≤ 50000:1 liegt.

8. Elektromechanischer Wandler nach einem der Ansprüche 1 bis 7,
**dadurch gekennzeichnet, dass**
die erste und die zweite Seite (1a, 1b) des dielektrischen Elastomer-Schichtverbunds (1) sinusförmig gewellt, dreieckförmig gewellt oder rechteckförmig gewellt ausgeführt sind.

9. Elektromechanischer Wandler nach einem der Ansprüche 1 bis 8,
**dadurch gekennzeichnet, dass**
die Wellenlänge der gewellt ausgeführten ersten und zweiten Seite (1 a, 1b) des dielektrischen Elastomer-Schichtverbunds (1) in einem Bereich von ≥ 1 µm bis ≤ 5000 µm liegt.

10. Elektromechanischer Wandler nach einem der Ansprüche 1 bis 9,
**dadurch gekennzeichnet, dass**
die Wellenamplitude der gewellt ausgeführten ersten und zweiten Seite (1 a, 1b) des dielektrischen Elastomer-Schichtverbunds (1) in einem Bereich von ≥ 0,3 µm bis ≤ 5000 µm liegt.

11. Verfahren zur Herstellung eines elektromechanischen Wandlers gemäß einem der Ansprüche 1 bis 10, umfassend die Schritte:
(a1) Bereitstellen einer dielektrischen Elastomer-Mittelschicht (2) mit einer ersten Seite und einer der ersten Seite gegenüberliegenden zweiten Seite, wobei die dielektrische Elastomer-Mittelschicht (2) ein Polyurethanpolymer umfasst,
(b1) Bereistellen einer ersten und einer zweiten dielektrischen Elastomer-Randschicht (3, 4), wobei die erste und die zweite dielektrische Elastomer-Randschicht (3, 4) jeweils eine erste und eine zweite Seite aufweisen, wobei die jeweils erste Seite (3a, 4a) der ersten und
der zweiten dielektrischen Elastomer-Randschicht (3, 4) gewellt ausgeführt sind unter Ausbildung von Erhebungen (7a, 7b) und Vertiefungen (8a, 8b),
(c1) Kontaktieren der gewellten ersten Seite (3a) der ersten dielektrischen Elastomer-Randschicht (3) mit einer ersten Elektrode (5) und Kontaktierung der ersten gewellten Seite (4a) der zweiten dielektrischen Elastomer-Randschicht (4) mit einer zweiten Elektrode (6),
wobei das Kontaktieren derart erfolgt, dass die erste und zweite Elektrode (5, 6) korrespondierend gewellt zu den gewellten ersten Seiten (3a, 4a) der erste und zweiten dielektrischen Elastomer-Randschicht (3, 4) ausgeführt sind.
(d1) Verbinden der jeweils zweiten Seiten der ersten und der zweiten dielektrischen Elastomer-Randschicht (3, 4) mit der ersten und der zweiten Seite der dielektrischen Elastomer-Mittelschicht (2) unter Ausbildung eines dielektrischen Elastomer-Schichtverbunds (1),

12. Verfahren nach Anspruch 11,
**dadurch gekennzeichnet, dass**
die dielektrischen Elastomer-Randschichten (3, 4) ein Silikonelastomer oder ein Polyurethanpolymer umfassen.

13. Verwendung eines elektromechanischen Wandlers nach einem der Ansprüche 1 bis 10 als Aktor, Sensor oder Generator.

14. Aktor, Sensor oder Generator, umfassend einen elektromechanischen Wandler nach einem der Ansprüche 1 bis 10.
